# EUROPEAN PATENT APPLICATION

(11) **EP 4 358 225 A2**
(43) Date of publication of application: **24.04.2024**
(21) Application number: 23196174.9
(22) Date of filing: 08.09.2023
(51) Int. Cl.: H01M 10/42, H02J 7/00

(54) **BATTERY PACK**

(30) Priority: 28.09.2022 CN 202211189909
(71) Applicant: Techtronic Cordless GP, Anderson, SC 29621 (US)
(72) Inventor: GUO, Xi, Dongguan City (CN); WEN, Chao, Dongguan City (CN); MA, Hai Bo, Kwai Chung (HK)
(74) Representative: Novagraaf Group

(57) **Abstract**

The present invention provides a battery pack, which can be electrically connected to an electrical device for power supply or connected to a charging device for charging, comprising an information acquiring module and a communication module. The information acquiring module can acquire the state information of the electrical device and/or the charging device electrically connected to the battery pack. The communication module is electrically connected to the information acquiring module. The battery pack can establish a communication connection with an external device through the communication module. When the communication connection between the battery pack and the external device is disconnected, the communication module can send broadcast information to the outside in a broadcast manner, the broadcast information comprising at least the state information of the battery pack, the electrical device and/or the charging device. According to the present invention, the state information of the battery pack and the electrical device or the charging device connected thereto can be obtained through the battery pack without establishing a communication connection with the external device. Thus, there is no need to set up special monitoring modules for the electrical device and the charging device, which can reduce the cost and simplify the operation method.

## Description

### Technical Field

The present invention relates to a battery pack, and in particular to a battery pack used for an electric tool and capable of being charged by a charging device.

### Background Art

When there is no fixed power supply or it is not convenient to directly supply power, a battery pack is usually attached to an electrical device for power supply. Examples of the electrical device may be electric tools that need to be moved frequently, household cleaning devices, kitchen devices, medical devices or the like. In addition, after the electricity of the battery pack is depleted, the battery pack may also be connected to a charging device for charging.

During the power supply or charging process of the battery pack, it is often necessary to continuously or intermittently monitor the states of the battery pack, the electrical device, and the charging device, so as to ensure that these devices are in normal working condition and to find out faults in time when the faults occur. In order to perform state monitoring, currently, a separate monitoring module/apparatus is set up for each device in most cases. Such a method leads to complicated control and operation, and higher costs.

### Summary of the Invention

An object of the present invention is to provide a battery pack. In the process of using or charging the battery pack, the state information of the electrical device or charging device connected thereto can be sent to the outside in a broadcast manner through the battery pack, so that an external device can obtain the state of the electrical device or charging device without communicating with any one of the battery pack, the electrical device and the charging device, which can simplify the control method and reduce the cost.

According to one aspect of the present invention, a battery pack is provided. The battery pack can be electrically connected to an electrical device for power supply or connected to a charging device for charging. The battery pack comprises:
an information acquiring module configured to be able to acquire the state information of the electrical device and/or the charging device electrically connected to the battery pack; and
a communication module electrically connected to the information acquiring module, wherein the battery pack can establish a communication connection with an external device through the communication module;
wherein when the communication connection between the battery pack and the external device is disconnected, the communication module can send broadcast information to the outside in a broadcast manner, the broadcast information comprising at least the state information of the battery pack.

In some embodiments, when the battery pack is connected to the electrical device or the charging device, the broadcast information further comprises the state information of the electrical device or the charging device.

In some embodiments, the broadcast information comprises at least one of the following parameters:
voltage, current, temperature, energy state, health state, locking state, unlocking state, current working mode, running time, serial number, fault identification number, and suggested connection request identification.

In some embodiments, the communication module periodically sends the broadcast information at a first predetermined interval.

In some embodiments, the communication module establishes a communication connection with the external device through Bluetooth Low Energy (BLE) technology and sends the broadcast information to the outside.

In some embodiments, the communication module is integrated in the battery pack, or the communication module is detachably mounted to the battery pack.

In some embodiments, when the battery pack establishes a communication connection with the external device, the external device can perform parameter setting for at least one of the battery pack, the electrical device and the charging device through the communication connection.

In some embodiments, the parameter setting comprises at least one of the following:
time update;
rotating speed and torque of the electrical device;
over-current protection;
over-temperature protection; and
switching between a locking state and an unlocking state of at least one of the battery pack, the electrical device and the charging device.

In some embodiments, when the battery pack establishes a communication connection with the external device, the external device is configured to be able to send a search instruction, and the battery pack can send prompt information in response to the search instruction.

In some embodiments, the battery pack is provided with a light emitting apparatus, the prompt information comprises a light signal sent by the light emitting apparatus, and preferably, the light signal flashes periodically at a second predetermined interval; and/or
the battery pack is provided with a sound generating apparatus, the prompt information comprises a sound signal sent by the sound generating apparatus, and preferably, the sound signal is a combination of syllables of different lengths and/or pitches in an arrangement.

In some embodiments, the prompt information lasts for a predetermined duration and then stops.

In some embodiments, the battery pack is provided with a stop switch, and the battery pack is configured to be able to stop sending the prompt information in response to the stop switch being operated.

In some embodiments, the battery pack further comprises a storage module, the storage module is configured to be able to store record information, and the record information at least comprises:
use time of the electrical device and the battery pack, and/or
an error event that occurs during use of the battery pack, the error event comprising the type of an error occurred and the state of the battery pack when the error occurs.

In some embodiments, when the battery pack establishes a communication connection with the external device, the external device is configured to be able to read the record information from the storage module.

In some embodiments, the battery pack is configured to automatically overwrite the earliest piece of record information after the storage space of the storage module is used up.

In some embodiments, the type of the error comprises at least one of the following: over-temperature protection, over-current protection, over-voltage protection, communication error, and battery cell imbalance.

The use of the battery pack according to the present invention can achieve at least the following beneficial effects:
1. The state information of the electrical device or charging device connected to the battery pack can be obtained through the battery pack, and thus there is no need to set up special monitoring modules for the electrical device and the charging device, which can reduce the cost.
2. The external device does not need to establish a communication connection with the battery pack to obtain the state information from the battery pack, and further, the external device does not need to be connected to the electrical device or charging device, so that the operation and control are simpler and more convenient.

### Brief Description of the Drawings

For a better understanding of the above and other objects, features, advantages and functions of the present invention, reference may be made to the preferred embodiments shown in the drawings. In the drawings, identical reference signs denote identical components. It should be understood by a person skilled in the art that the drawings are intended to schematically illustrate preferred embodiments of the present invention, without imposing any restrictions on the scope of the present invention, and that the components in the drawings are not drawn to scale.
FIG. 1 is a schematic diagram of a battery pack according to the present invention and an electrical device and a charging device electrically connected to the battery pack;
FIG. 2 is a schematic diagram of sending broadcast information when the battery pack shown in FIG. 1 is connected to the electrical device; and
FIG. 3 is a schematic diagram of sending broadcast information when the battery pack shown in FIG. 1 is connected to the charging device.

Description of reference signs:
- 100: battery pack
- 110: housing
- 111: slot
- 120: battery unit
- 130: information acquiring module
- 140: communication module
- 150: light emitting apparatus
- 160: stop switch
- 170: storage module
- 200: electrical device
- 300: charging device
- 400: external device

### Detailed Description of the Invention

Specific embodiments of the present invention are now described in detail with reference to the drawings. The embodiments described here are merely preferred embodiments according to the present invention. A person skilled in the art could conceive of other embodiments of implementing the present invention on the basis of the preferred embodiments, and the other embodiments likewise fall within the scope of the present invention.

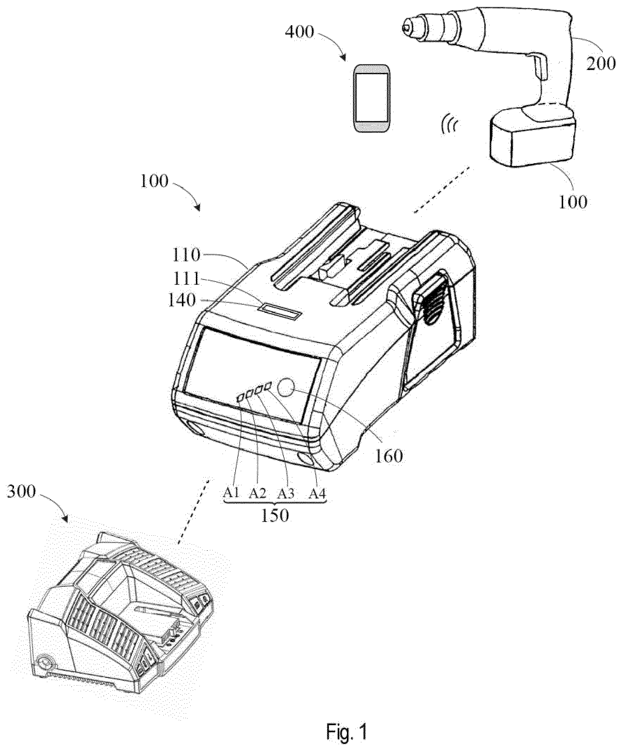

The present invention provides a battery pack. As shown in FIGS. 1 to 3, a battery pack 100 according to some preferred embodiments includes a housing 110 and a battery unit 120 composed of a plurality of battery cells. The battery unit 120 is arranged in an accommodation space formed by the housing 110, and used for storing electric energy. The housing 110 is further provided with a connection structure (not shown), the connection structure may be connected to another connection structure with a complementary shape on an electrical device 200, so as to fix the battery pack 100 to the electrical device, and corresponding electric terminals of the two are electrically connected to supply power to the electrical device. Specifically, the electrical device 200 may be an electric tool, a household cleaning device, a kitchen device, a medical device or the like. Preferably, the battery cells of the battery unit 120 may be rechargeable secondary battery cells. The battery pack 100 may be connected to a charging device 300 for charging when the electricity quantity drops.

In addition, according to the present invention, the battery pack 100 further includes an information acquiring module 130 and a communication module 140. The information acquiring module 130 is electrically connected to the battery unit 120, a sensor and other components to acquire the state information of the battery unit 120. For example, the information acquiring module 130 may acquire the voltage, current, temperature, state of charge (SOC), state of health (SOH) and the like of each battery cell of the battery unit 120. When the battery pack 100 is connected to the electrical device 200 or the charging device 300, the information acquiring module 130 may communicate with a connected paired device to obtain the state information of the device. For example, the information acquiring module 130 may acquire the working mode, operating time, locking/unlocking state, serial number, occurrence or non-occurrence of a fault, fault identification number (when the fault occurs), etc., of the electrical device 200. For the charging device 300, the information acquiring module 130 may acquire the charging mode, charging current and voltage, temperature, serial number, occurrence or non-occurrence of a fault, and fault identification number (when the fault occurs), etc., of the charging device 300. The information acquiring module 130 may preferably be a part of a battery management system (BMS) of the battery pack 100. Alternatively, the information acquiring module 130 may also be an independent operating module.

The battery pack 100 may establish a communication connection with an external device 400 such as a smartphone through the communication module 140 (for example, by means of a specific application program pre-installed on the external device 400). The communication module 140 is further electrically connected to the above information acquiring module 130. In this way, after the communication connection is established, the battery pack 100 may send the state information of the battery pack 100, the electrical device 200 and/or the charging device 300 acquired by the information acquiring module 140 to the external device 400. Preferably, the communication module 140 may have a wireless communication mode, such as wireless communication based on Bluetooth technology, Bluetooth Low Energy (BLE) technology, or the like. That is, the communication connection between the battery pack 100 and the external device is a wireless connection.

Further, according to the technical solution of the present invention, the communication module 140 is further configured to be able to send broadcast information to the outside in a broadcast manner when the communication connection between the battery pack 100 and the external device 400 is disconnected, and the broadcast information may include the state information of at least one of the battery pack 100, the electrical device 200 and the charging device 300. The advantage of such a setting is that the trouble of having to establish a communication connection between the external device 400 and the communication module 140 to receive the state information is omitted, and the operation steps are simpler and more convenient.

Preferably, when the communication module 140 does not establish a communication connection with the external device 400, the communication module 140 may periodically send the broadcast information to the outside, for example, once every 2 s. The interval between two adjacent broadcasts may be referred to as a first predetermined interval. Within a predetermined range from the battery pack 100 (that is, a wireless signal loaded with the broadcast information has sufficient strength to be sensed), the external device 400 installed with a specific application program may receive the broadcast information, thereby acquiring the state information of each device without establishing a communication connection.

In some preferred embodiments, the communication module 140 may be configured in the form of a separate electronic card, and the electronic card is integrally provided with necessary components for wireless communication such as a control circuit and an antenna. Correspondingly, as shown in FIG. 1, the housing 110 of the battery pack 100 is provided with a slot 111. The electronic card may be attached to the battery pack 100 by being inserted into the slot 111, and electrically connected to the information acquiring module 130 through a structure such as an electrical contact. In some embodiments, the communication module 140 may further be integrated in the battery pack 100, and may even be configured as a part of the BMS of the battery pack 100.

It can be understood that, without establishing a communication connection, the external device 400 can only receive the state information of at least one of the battery pack 100, the electrical device 200 and the charging device 300, but cannot perform setting of the battery pack 100, the electrical device 200 and/or the charging device 300. Preferably, the setting function may be realized when the external device 400 establishes a communication connection with the battery pack 100. In some embodiments, the communication connection may be authenticated by means of a handshake request so as to realize the connection.

The above communication connection request is actively initiated by the external device 400. Preferably, in order to remind an operator of the external device 400 to establish a communication connection, the broadcast information sent by the communication module 140 without communication connection may further include suggested connection request identification.

Once the communication connection is established, the external device 400 may be used to set a working parameter of the battery pack 100, the electrical device 200 or the charging device 300. The set parameter may be, for example, time update, working mode, over-current protection, over-temperature protection or the like. When the electrical device 200 is an electric tool, the working mode may specifically be a parameter such as tool rotation speed or torque. In addition, the locking state and unlocking state of the battery pack 100, the electrical device 200 or the charging device 300 may also be switched through the external device 400.

Preferably, after the communication connection between the external device 400 and the battery pack 100 is established, the external device 400 may further determine the location of the battery pack 100 by sending a search instruction. When the battery pack 100 receives the search instruction sent by the external device 400, the battery pack 100 may send a prompt information to help the operator find the battery pack 100. In some embodiments, the prompt information may include a light signal. For example, as shown in FIG. 1, the battery pack 100 may be provided with a light emitting apparatus 150 such as an LED lamp. In response to receiving the search instruction, the light emitting apparatus may flash periodically, for example once every 400 ms. Such a setting is advantageous in a darker environment. The period of flashing may be referred to as a second predetermined interval. Preferably, the light emitting apparatus 150 may be an electricity meter for displaying the remaining electricity quantity of the battery pack 100. In this way, the electricity meter is used to send a light signal for prompting, reducing the number of components of the battery pack 100. It is helpful to reduce the cost. In some embodiments, the prompt information may include a sound signal. For example, the battery pack 100 may be provided with a buzzer or a speaker configured to send a sound signal in response to receiving the search instruction. The sound signal may preferably be a combination of syllables of different lengths and/or pitches in an arrangement, such as a prompt tone "di--, didi" with 1 long sound and 2 short sounds, or may also be a voice prompt.

Preferably, the battery pack 100 is configured to stop sending the prompt information after the prompt information lasts for a predetermined duration. The duration may be set according to the complexity of the environment where the battery pack 100 is located, for example, 1 minute, so that the operator can find the battery pack 100 in time. As shown in FIG. 1, the battery pack 100 is further provided with a stop switch 160. When the operator finds the battery pack 100 within the duration, the operator may stop the battery pack 100 from sending the prompt information by operating the stop switch 160. The stop switch 160 may be in the form of a button or a toggle.

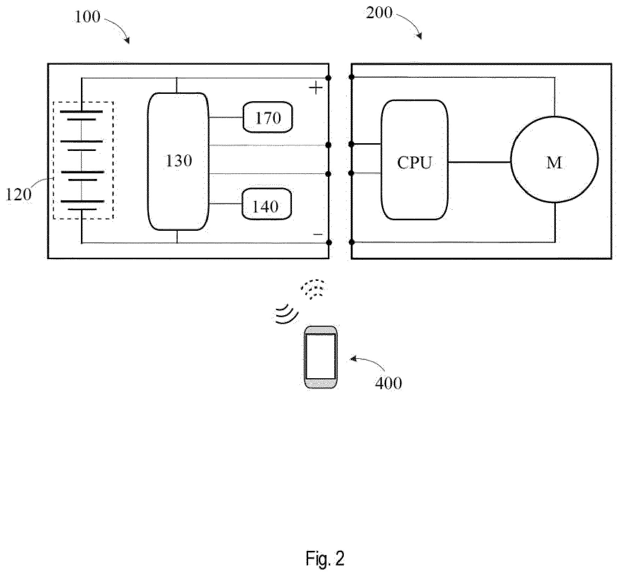

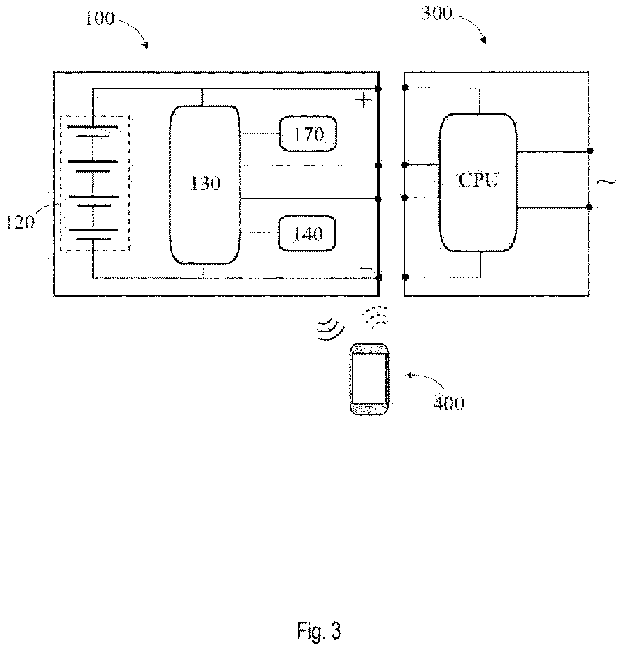

In addition, as shown in FIGS. 2 and 3, the battery pack 100 may further be provided with a storage module 170, and the storage module 170 is used for storing record information related to the battery pack 100 and the electrical device 200 or charging device 300 connected to the battery pack 100 in a paired manner. The recorded information may specifically include, for example, the use time and charging time of the electrical device 200 and the battery pack 100, and an error event that occurs during the use of the battery pack 100. The error event may include the type of an error occurred (e.g., over-temperature protection, over-voltage protection, over-current protection, communication error, battery cell unbalance, etc.) and the state of the battery pack 100 when the error occurs. The use of the battery pack 100 may be a discharging process in which the battery pack 100 is connected to the electrical device 200, or a charging process in which the battery pack 100 is connected to the charging device 300.

Preferably, when the external device 400 establishes a communication connection with the battery pack 100, the external device 400 may read the record information recorded in the storage module 170 to know the use history of the battery pack 100 and a device connected thereto in a paired manner. In some embodiments, the storage module 170 may be integrated in the battery pack 100 to be configured as a part of the BMS, or the storage module 170 may also be attached to the battery pack 100 as a separate component like the communication module 140 shown in FIG. 1. In addition, when the storage space of the storage module 170 is used up, the newly generated record information may overwrite the earliest piece of record information, so as to avoid the situation that it is impossible to record due to insufficient storage space.

The above description of various embodiments of the present invention is provided to a person of ordinary skill in the relevant art for descriptive purposes. The present invention is not intended to be exclusive or limited to a single disclosed embodiment. On the basis of what is described above, a person of ordinary skill in the art will understand various substitutes for and variants of the present invention. Therefore, although some alternative embodiments have been described specifically, a person of ordinary skill in the art will understand or develop with relative ease other embodiments. The present invention is intended to include all substitutes for, alterations to, and variants of the present invention described herein, as well as other embodiments falling within the spirit and scope of the present invention described above.

## Claims

1. A battery pack, wherein the battery pack (100) can be electrically connected to an electrical device (200) for power supply or connected to a charging device (300) for charging, **characterised in that** the battery pack (100) comprises:
an information acquiring module (130) configured to be able to acquire the state information of the electrical device (200) and/or the charging device (300) electrically connected to the battery pack (100); and
a communication module (140) electrically connected to the information acquiring module (130), wherein the battery pack (100) can establish a communication connection with an external device (400) through the communication module (140);
wherein when the communication connection between the battery pack (100) and the external device (400) is disconnected, the communication module (140) can send broadcast information to the outside in a broadcast manner, the broadcast information comprising at least the state information of the battery pack (100).

2. The battery pack according to claim 1, **characterised in that** when the battery pack (100) is connected to the electrical device (200) or the charging device (300), the broadcast information further comprises the state information of the electrical device (200) or the charging device (300).

3. The battery pack according to claim 1 or 2, wherein the broadcast information comprises at least one of the following parameters:
voltage, current, temperature, state of charge, state of health, locking state, unlocking state, current working mode, operating time, serial number, fault identification number, and suggested connection request identification.

4. The battery pack according to claim 1 or 2, **characterised in that** the communication module (140) periodically sends the broadcast information at a first predetermined interval.

5. The battery pack according to claim 1 or 2, **characterised in that** the communication module (140) establishes a communication connection with the external device (400) through Bluetooth Low Energy (BLE) technology and sends the broadcast information to the outside.

6. The battery pack according to claim 5, **characterised in that** the communication module (140) is integrated in the battery pack (100), or the communication module (140) is detachably mounted to the battery pack (100).

7. The battery pack according to claim 1, **characterised in that** when the battery pack (100) establishes a communication connection with the external device (400), the external device (400) can perform parameter setting for at least one of the battery pack (100), the electrical device (200) and the charging device (300) through the communication connection.

8. The battery pack according to claim 7, wherein the parameter setting comprises at least one of the following:
time update;
rotating speed and torque of the electrical device (200);
over-current protection;
over-temperature protection; and
switching between a locking state and an unlocking state of at least one of the battery pack (100), the electrical device (200) and the charging device (300).

9. The battery pack according to claim 1, **characterised in that** when the battery pack (100) establishes a communication connection with the external device (400), the external device (400) is configured to be able to send a search instruction, and the battery pack (100) can send prompt information in response to the search instruction.

10. The battery pack according to claim 9, **characterised in that**
the battery pack (100) is provided with a light emitting apparatus (150), the prompt information comprises a light signal sent by the light emitting apparatus (150), and the light signal flashes periodically at a second predetermined interval; and/or
the battery pack (100) is provided with a sound generating apparatus, the prompt information comprises a sound signal sent by the sound generating apparatus, and the sound signal is a combination of syllables of different lengths and/or pitches in an arrangement.

11. The battery pack according to claim 9, **characterised in that** the prompt information lasts for a predetermined duration and then stops.

12. The battery pack according to claim 9, **characterised in that** the battery pack (100) is provided with a stop switch (160), and the battery pack (100) is configured to be able to stop sending the prompt information in response to the stop switch (160) being operated.

13. The battery pack according to claim 1, **characterised in that** the battery pack (100) further comprises a storage module (170), the storage module (170) is configured to be able to store record information, and the record information at least comprises:
use time of the electrical device (200) and the battery pack (100), and/or
an error event that occurs during use of the battery pack (100), the error event comprising the type of an error occurred and the state of the battery pack (100) when the error occurs;
wherein when the battery pack (100) establishes a communication connection with the external device (400), the external device (400) is configured to be able to read the record information from the storage module (170).

14. The battery pack according to claim 13, **characterised in that** the battery pack (100) is configured to automatically overwrite the earliest piece of recorded information after the storage space of the storage module (170) is used up.

15. The battery pack according to claim 13, wherein the type of the error comprises at least one of the following: over-temperature protection, over-current protection, over-voltage protection, communication error, and battery cell imbalance.
